# FASCICULE DE BREVET EUROPEEN

(11) **EP 2 510 553 B1**
(45) Date de publication et mention de la délivrance du brevet: **07.12.2016**
(21) Numéro de dépôt: 09804279.9
(22) Date de dépôt: 18.12.2009
(51) Int. Cl.: H01L 31/048, H01L 31/05

(54) **CELLULE PHOTOVOLTAÏQUE, PROCÉDÉ D'ASSEMBLAGE D'UNE PLURALITÉ DE CELLULES ET ASSEMBLAGE DE PLUSIEURS CELLULES PHOTOVOLTAÏQUES**
PV-ZELLE, VERFAHREN ZUR MONTAGE MEHRERER ZELLEN UND ANORDNUNG AUS MEHREREN PV-ZELLEN
PHOTOVOLTAIC CELL, METHOD FOR ASSEMBLING PLURALITY OF CELLS, AND ASSEMBLY OF A PLURALITY OF PHOTOVOLTAIC CELLS

(30) Priorité: 09.12.2009 FR 0905964
(43) Date de publication de la demande: 17.10.2012
(73) Titulaire: Commissariat à l'Énergie Atomique et aux Énergies Alternatives, 75015 Paris (FR)
(72) Inventeur: VICARD, Dominique, 38190 Bernin (FR); BRUN, Jean, F-38800 Champagnier (FR); PERICHON, Pierre, F-38500 Voiron (FR)
(74) Mandataire: Talbot, Alexandre
(86) Numéro de dépôt international: PCT/FR2009/001462
(87) Numéro de publication internationale: WO 2011/070240

(56) Documents cités:
- EP-A1- 0 385 843
- EP-A2- 0 474 349
- JP-A- 9 260 707
- JP-A- 2002 246 628
- JP-A- 2002 324 596
- JP-A- 2008 135 646
- US-A- 5 391 235
- US-A1- 2003 006 730

## Description

### Domaine technique de l'invention

L'invention est relative à une cellule photovoltaïque munie d'un bloc incluant au moins un substrat semiconducteur dans lequel est formée au moins une jonction photovoltaïque connectée à un premier élément de contact électrique d'un premier pôle et à un second élément de contact électrique d'un second pôle.

### État de la technique

Les panneaux photovoltaïques actuels comportent des lignes de cellules solaires reliées électriquement en série.

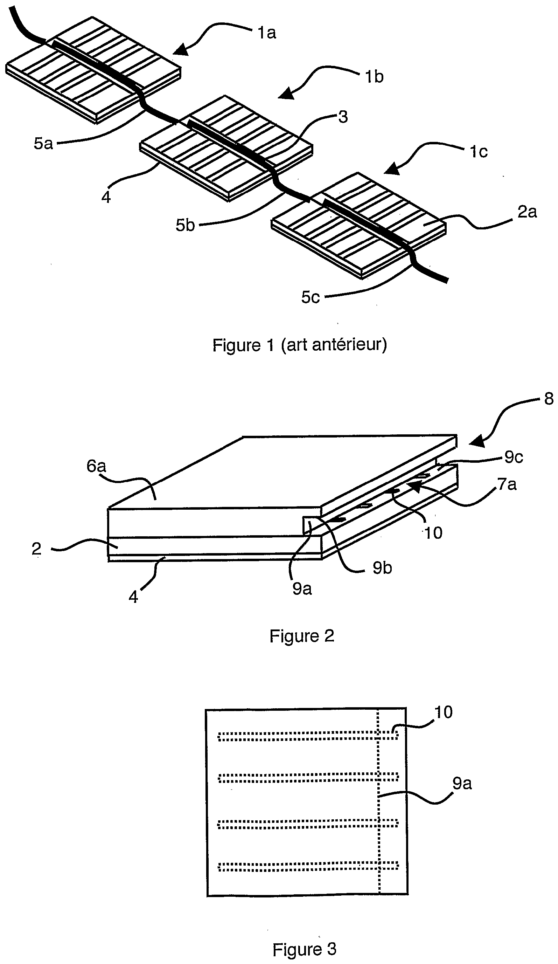

La figure 1 représente trois cellules solaires 1 a, 1 b, 1 c reliées en série. Une cellule comporte un substrat 2a semiconducteur dans lequel est formée au moins une jonction PN. Une cellule a en général une forme de carré d'environ 16cm de côté. De part et d'autre du substrat 2a sont disposés des éléments de contact électrique. Sur la figure 1, un premier élément de contact électrique 3 d'un pôle négatif est disposé sur la face de chaque cellule 1 a, 1 b, 1 c destinée à être orientée vers le soleil. Afin d'augmenter le rendement d'une cellule solaire tout en laissant passer les photons, le premier élément de contact électrique 3 est constitué par une électrode munie de part et d'autre de son axe longitudinal de peignes. Un second élément de contact électrique d'un pôle positif est formé par une couche métallique 4 recouvrant la face arrière de la cellule. Une série de cellules solaires est réalisée par soudure de bandes 5a, 5b, 5c électriquement conductrices entre deux cellules adjacentes. Ainsi, une première cellule 1 a est reliée à une deuxième cellule 1 b par une bande 5a soudée à une extrémité à la couche métallique 4 de la deuxième cellule 1 b et à une autre extrémité au premier élément de contact électrique 3 de la première cellule 1 a. La deuxième cellule 1 b est reliée à une troisième cellule 1 c par une bande 5b soudée à une extrémité à la couche métallique 4 de la troisième cellule 1 c et à une autre extrémité au premier élément de contact électrique 3 de la deuxième cellule 1 b. L'opération qui consiste à relier plusieurs cellules entre elles devient de plus en plus difficile à réaliser étant donné que les technologies actuelles tendent à amincir les cellules afin d'économiser les matériaux, notamment lorsqu'elles sont réalisées sur des substrats de silicium.

En effet, les cellules solaires rigides sont à ce jour majoritairement produites à partir de plaquettes de silicium de plus en plus fines. Les matériaux et procédés de fabrication font l'objet de programmes de recherche pour réduire les coûts de production en baissant la quantité de silicium par plaquette. Pour cela, les plaquettes de silicium sont tout d'abord passées de 300μm d'épaisseur à 200μm d'épaisseur, et l'on pense maintenant atteindre les 180μm voire les 150μm d'épaisseur. Cette diminution d'épaisseur entraîne la fragilisation des cellules et rend difficile leur manipulation.

De plus, une fois les cellules reliées pour former un panneau, le panneau est encapsulé dans un cadre massif pour protéger l'ensemble. Le panneau final est souvent relativement épais.

Par ailleurs, la réalisation de panneaux solaires souples nécessite de façon générale l'utilisation de matériaux semiconducteurs « souples » moins performants que les matériaux semiconducteurs « rigides » tels que le silicium monocristallin.

Le document JP 2008135646 divulgue une cellule photovoltaïque comprenant des première et deuxième faces principales recouvertes d'une couche de matériau protecteur. Chaque couche de matériau protecteur comporte deux rainures, et forme deux trous traversants après assemblage sur la cellule photovoltaïque. L'intérieur de chaque trou traversant est rempli avec un matériau conducteur, et des éléments filaires électriquement conducteurs sont placés aux entrées des rainures et mis en contact avec le matériau conducteur. Ces éléments filaires électriquement conducteurs permettent la connexion de plusieurs cellules photovoltaïques.

### Objet de l'Invention

L'objet de l'invention consiste à réaliser une cellule photovoltaïque selon la revendication 1, facile à concevoir et à manipuler, et permettant de réaliser des assemblages de faible épaisseur et souples.

Ce but est atteint en ce que la cellule comporte un premier capot transparent disposé sur une première face du bloc et délimitant avec ledit bloc de la cellule une première rainure de logement d'un premier élément filaire électriquement conducteur.

Selon un mode de réalisation la cellule comporte un second capot disposé sur une seconde face du bloc, opposée à la première face du bloc, et délimitant avec le bloc de la cellule une deuxième rainure de logement d'un deuxième élément filaire électriquement conducteur.

Selon une variante, le second capot et/ou premier capot sont placés directement sur le substrat semiconducteur.

Selon un autre mode de réalisation, au moins un des éléments de contact électrique connecté à la jonction photovoltaïque comprend un élément filaire encastré dans une rainure.

Selon un autre mode de réalisation, au moins un des éléments de contact électrique comporte une pluralité de branches conductrices disposées sur une face du substrat semiconducteur, lesdites branches étant destinées à être en contact ou reliées à un élément filaire.

Selon un autre mode de réalisation, le second capot étant transparent, le bloc comporte deux substrats semiconducteurs incluant des jonctions photovoltaïques séparées par une couche métallique, la cellule comportant une troisième rainure longitudinale de logement d'un troisième élément filaire électriquement conducteur destiné à être relié à ladite couche métallique.

Selon un autre mode de réalisation, le bloc comporte deux substrats semiconducteurs incluant des jonctions photovoltaïques séparées par un diélectrique, la cellule comportant des troisième et quatrième rainures formées respectivement au niveau d'une face latérale à l'interface entre la couche de diélectrique et les substrats semiconducteurs associés.

Un autre objet de l'invention consiste en un assemblage de cellules photovoltaïques selon la revendication 13 comprenant plusieurs cellules photovoltaïques reliées les unes aux autres par plusieurs éléments filaires, chaque élément filaire étant encastré dans les rainures d'au moins deux cellules photovoltaïques.

Un autre objet de l'invention consiste en un procédé d'assemblage d'une pluralité de cellules photovoltaïques selon la revendication 14, chaque cellule comportant des première et deuxième rainures formées au niveau d'une même face latérale, le procédé comporte les étapes successives suivantes :
- le positionnement des cellules sous la forme d'au moins une ligne de manière à former une première et une deuxième rangées de rainures, la première rainure d'une cellule étant alignée avec la deuxième rainure de la cellule adjacente,
- le câblage de chaque ligne de cellules, un premier fil électriquement conducteur étant inséré dans chaque rainure de la première rangée de rainures, et un deuxième fil électriquement conducteur étant inséré dans chaque rainure de la deuxième rangée de rainures,
- le sectionnement alternatif des premier et deuxième fils entre deux cellules adjacentes,
- le retournement d'une cellule photovoltaïque sur deux afin d'orienter tous les premiers capots des cellules photovoltaïques d'un même côté.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre trois cellules solaires reliées selon une technique connue de l'art antérieur.
La figure 2 illustre un premier mode de réalisation d'une cellule photovoltaïque selon l'invention.
La figure 3 illustre une vue de dessus de la cellule de la figure 2:
La figure 4 illustre une variante de réalisation du premier mode de réalisation.
La figure 5 illustre un deuxième mode de réalisation d'une cellule selon l'invention.
La figure 6 illustre une variante de réalisation du deuxième mode de réalisation.
La figure 7 illustre un troisième mode de réalisation d'une cellule photovoltaïque munie de trois rainures.
La figure 8 illustre un quatrième mode de réalisation d'une cellule photovoltaïque selon l'invention.
La figure 9 illustre un cinquième mode de réalisation d'une cellule photovoltaïque selon l'invention.
Les figures 10 à 16 illustrent un procédé d'assemblage d'une pluralité de cellules photovoltaïques sous la forme d'une ligne.
La figure 17 illustre une variante de mise en oeuvre du procédé d'assemblage d'une pluralité de cellules photovoltaïques.
La figure 18 illustre une pluralité de cellules photovoltaïques disposées sous forme de matrice.
Les figures 19 à 22 illustrent un exemple de procédé de fabrication de cellules photovoltaïques.

### Description de modes préférentiels de réalisation

Dans les modes de réalisation illustrés aux figures 2 à 9, une cellule photovoltaïque est munie d'un bloc 2 incluant au moins un substrat 2a semiconducteur dans lequel au moins une jonction photovoltaïque est formée. Une jonction photovoltaïque peut être constituée d'une jonction PN. Chaque jonction photovoltaïque est connectée à un premier élément de contact électrique d'un premier pôle et à un second élément de contact électrique d'un second pôle. La cellule photovoltaïque comporte un premier capot 6a transparent disposé sur une première face du bloc 2 et délimitant avec le bloc 2 une première rainure 7a de logement d'un premier élément filaire électriquement conducteur.

De préférence, la première rainure 7a est une rainure longitudinale de logement du premier élément filaire située au niveau d'une face latérale 8 de la cellule.

Les premier et second pôles correspondent, par exemple, à une anode et une cathode. Les premier et second éléments de contact électrique permettent la collecte des charges, électrons et trous, générés dans le substrat semiconducteur.

Le capot 6a comporte, de préférence, un épaulement réalisé au niveau de l'une de ses arêtes longitudinales. Le bloc 2 a, de préférence, des dimensions sensiblement égales aux dimensions du premier capot 6a. Ainsi, lorsque le premier capot 6a est en position sur le bloc 2 comme illustré à la figure 2, et que la face du premier capot 6a comportant une entaille formant l'épaulement est orientée vers la première face du bloc 2, la première rainure 7a longitudinale est naturellement délimitée. La première rainure 7a est alors formée d'un fond 9a relié à deux parois latérales 9b, 9c. La paroi latérale 9b et le fond 9a sont délimités par l'épaulement du premier capot 6a et l'autre paroi latérale 9c est délimitée par une portion laissée libre de la première face du bloc 2.

Le premier élément filaire est, de préférence, encastré longitudinalement dans la première rainure 7a. Par encastrement longitudinal, on entend que l'axe de l'élément filaire est sensiblement parallèle à l'axe longitudinal de la rainure dans laquelle il est encastré.

Selon un premier mode de réalisation particulier illustré aux figures 2 et 3, le bloc 2 est constitué uniquement d'un substrat semiconducteur et le premier capot 6a peut être placé directement sur le substrat semiconducteur. Le premier élément de contact électrique peut comporter une pluralité de branches conductrices 10 disposées sur une première face du substrat. Le second élément de contact électrique peut comporter une couche métallique 4 formée sur une seconde face du substrat semiconducteur opposée à la première face du substrat. Autrement dit, la couche métallique 4 recouvre le substrat semiconducteur. Les branches 10 sont, de préférence, sensiblement perpendiculaires à un axe longitudinal de la première rainure 7a, et sont disposées entre le premier capot 6a et la première face du substrat. De préférence, les branches sont reliées électriquement au niveau de la rainure par une branche de liaison électriquement conductrice (non représentée) recouvrant au moins une partie de la paroi latérale 9c de la première rainure 7a formée par la portion de substrat. Les branches 10 sont, de préférence, espacées l'une par rapport à l'autre de sorte à optimiser la surface active de la cellule. Autrement dit, au moins un des éléments de contact électrique comporte une pluralité de branches conductrices 10 disposées sur une face du substrat semiconducteur, lesdites branches 10 étant destinées à être en contact ou reliées à un élément filaire.

Les branches 10 et la branche de liaison peuvent être constituées d'un métal ou d'un autre matériau conducteur déposé, ou formé, sur le substrat 2.

Selon une variante, la branche de liaison n'est pas nécessaire, les branches 10 couvrent une partie de la paroi latérale 9c de la première rainure 7a formée par la portion libre du substrat semiconducteur. Les branches 10 sont reliées électriquement entre elles lorsque le premier élément filaire électriquement conducteur est encastré longitudinalement dans la première rainure 7a. Lorsque ledit premier élément filaire est en contact électrique avec le substrat, par exemple lorsque le fil est constitué uniquement d'un matériau conducteur, ledit premier élément filaire constitue alors une partie du premier élément de contact électrique. Autrement dit, au moins un des éléments de contact électrique connecté à la jonction photovoltaïque comprend un élément filaire encastré dans une rainure.

Selon une autre variante, si la cellule, et plus particulièrement le substrat semiconducteur, a des dimensions inférieures à une distance minimale permettant d'attirer un grand nombre d'électrons ou de trous générés par l'absorption de photons, alors les branches 10 ne sont pas indispensables. Le premier élément filaire électriquement conducteur, une fois encastré longitudinalement dans la première rainure 7a, peut à lui seul faire office de premier élément de contact électrique.

Un assemblage en série de telles cellules avec des éléments filaires électriquement conducteurs comporte, entre chaque cellule, un élément filaire reliant électriquement la première rainure 7a d'une première cellule à la couche métallique 4 d'une deuxième cellule.

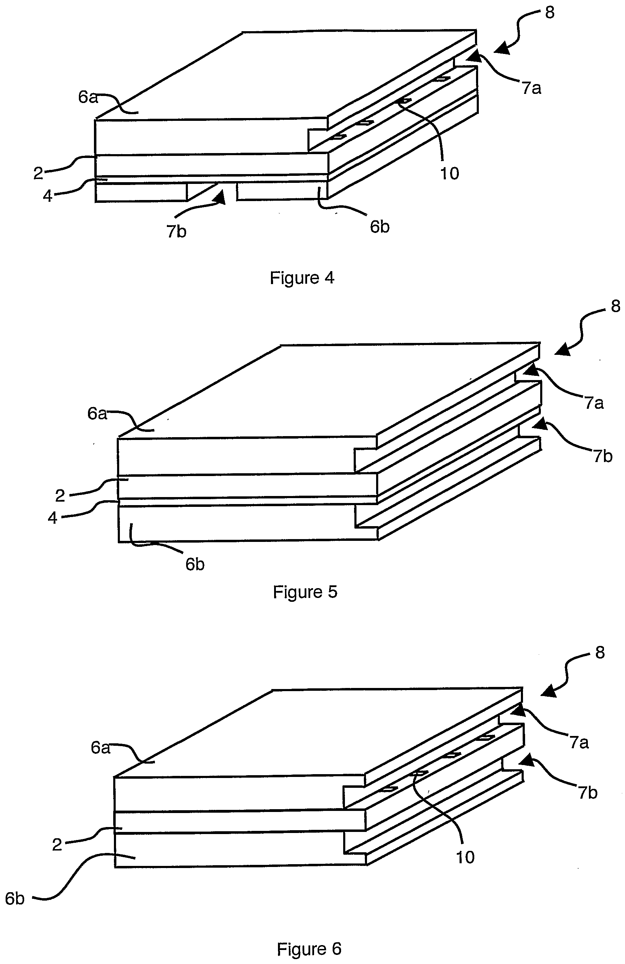

Selon une variante de réalisation du premier mode de réalisation illustrée à la figure 4, la face libre de la couche métallique 4 est recouverte par un second capot 6b au centre duquel est réalisée une deuxième rainure 7b, de préférence d'axe longitudinal sensiblement parallèle à l'axe longitudinal de la première rainure 7a. Cette deuxième rainure 7b permet de faciliter l'assemblage d'une série de cellules en délimitant une rainure dans laquelle un deuxième élément filaire électriquement conducteur pourra être inséré, par exemple par encastrement longitudinal. Comme sur la figure 4, la cellule peut comporter un second capot 6b disposé sur une seconde face du bloc 2, opposée à la première face du bloc 2, et délimitant avec le bloc 2 de la cellule une deuxième rainure 7b de logement d'un deuxième élément filaire électriquement conducteur.

Bien entendu, si la cellule est de petites dimensions, la couche métallique peut être supprimée et le second élément de contact électrique est alors formé par le deuxième élément filaire électriquement conducteur en contact avec le substrat. Dans ce cas, seul le second capot 6b subsiste pour protéger le substrat semiconducteur.

Selon une autre variante non représentée, la couche métallique 4 est suffisamment épaisse pour réaliser dans la face libre de cette couche métallique 4 la deuxième rainure 7b. Le capot 6b n'est alors pas indispensable.

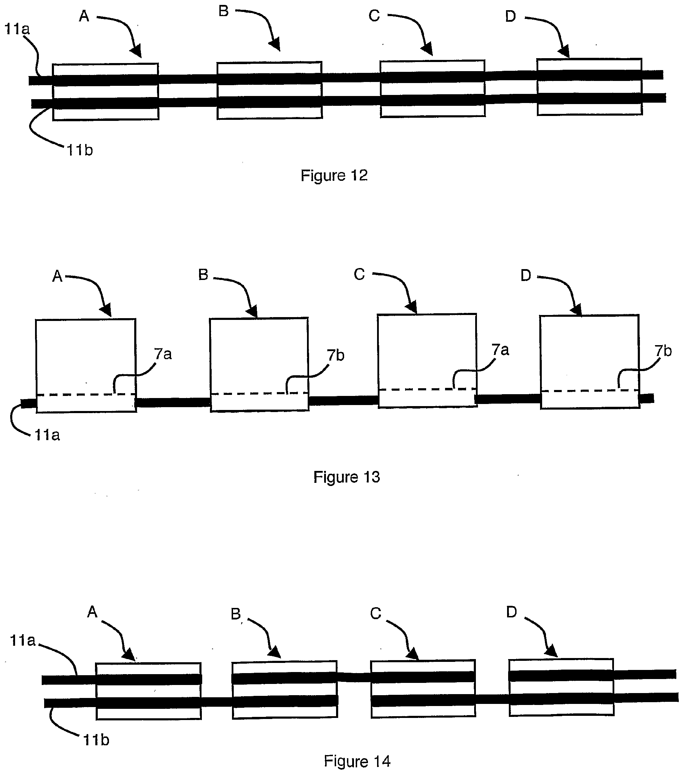

Selon un deuxième mode de réalisation illustré à la figure 5 et dans lequel le bloc 2 comporte un unique substrat semiconducteur muni d'une jonction photovoltaïque, la cellule comporte un second capot 6b disposé sur une seconde face du substrat semiconducteur, opposée à la première face dudit substrat, et délimitant avec le substrat, de préférence dans une face latérale 8 de la cellule, une deuxième rainure 7b longitudinale de logement d'un deuxième élément filaire électriquement conducteur. Cette deuxième rainure 7b est, de préférence, sensiblement parallèle à la première rainure 7a, c'est-à-dire qu'elle est d'axe longitudinal parallèle à l'axe longitudinal de la première rainure 7a. La deuxième rainure 7b est située, de préférence, dans la même face latérale 8 que la première rainure 7a pour faciliter le procédé d'assemblage d'une pluralité de cellules, comme cela est décrit ci-après en relation avec les figures 12 et 13. Les premier et second éléments de contact électrique peuvent être au moins constitués en tout ou partie par les premier et deuxième éléments filaires respectivement encastrés longitudinalement dans les première 7a et deuxième 7b rainures.

Sur la figure 5, une couche métallique 4 est, de préférence, interposée entre le substrat semiconducteur et le second capot 6b pour former tout ou partie du second élément de contact électrique, ladite couche métallique 4 étant en contact électrique avec le deuxième élément filaire après son encastrement dans la deuxième rainure 7b. Comme décrit précédemment, le mode de réalisation de la figure 5 peut aussi intégrer des branches disposées entre le premier capot 6a et le substrat semiconducteur.

Selon une variante du second mode de réalisation illustrée à la figure 6, le deuxième capot 6b est lui aussi transparent. Ceci permet de récupérer des charges produites par des photons venant interagir dans le semiconducteur en traversant le premier capot 6a et/ou le second capot 6b. Dès lors la couche métallique 4 peut être remplacée par des branches, similaires aux branches 10 précédemment décrites, et interposées entre le second capot 6b et le substrat semiconducteur. Les branches conductrices sont, par exemple, perpendiculaires à un axe longitudinal de la seconde rainure 7b. Les branches conductrices peuvent être reliées électriquement par une branche conductrice de liaison. Cette branche de liaison est, de préférence, placée sous le futur élément filaire encastré, c'est-à-dire sur la paroi latérale de la deuxième rainure 7b formée par la portion de substrat, afin de ne pas augmenter l'obstruction aux photons induite par la présence des branches conductrices en surface du substrat et la présence du futur élément filaire.

Comme indiqué précédemment, si la cellule est de petites dimensions, les branches ne sont pas indispensables. Les premier et deuxième éléments filaires électriquement conducteurs respectivement encastrés longitudinalement dans les première et deuxième rainures 7a, 7b peuvent former les premier et second éléments de contact électrique à eux seuls. Dès lors, le premier 6a et /ou le second 6b capot peuvent être placés directement sur le substrat semiconducteur.

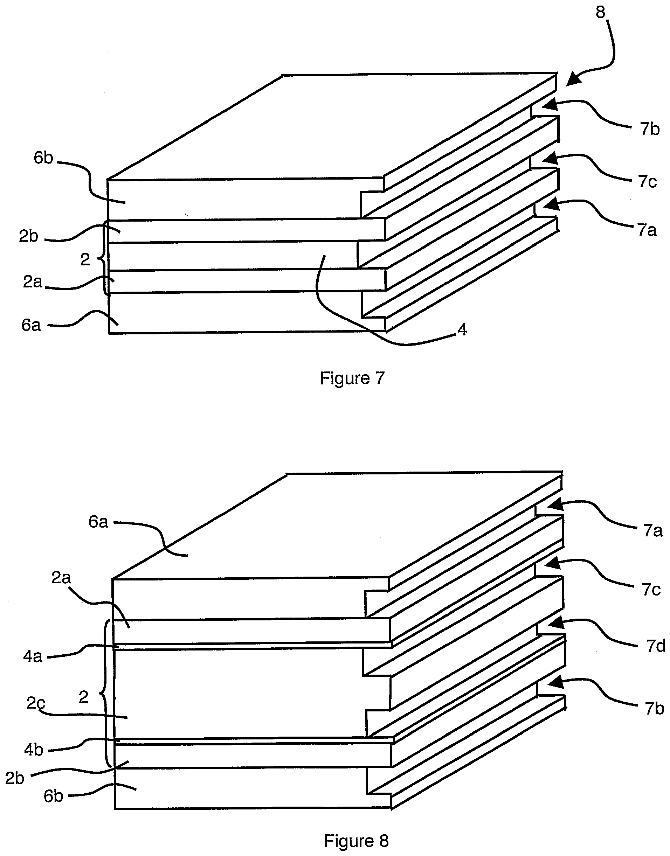

Selon un troisième mode de réalisation illustré à la figure 7, la cellule comprend un bloc central 2 pris en sandwich par deux capots 6a, 6b. Plus précisément, la cellule comprend un empilement d'un premier capot 6a transparent, d'un premier substrat semiconducteur 2a muni d'une première jonction photovoltaïque, d'une couche métallique 4, d'un second substrat semiconducteur 2b muni d'une seconde jonction photovoltaïque, et d'un deuxième capot 6b transparent. Le premier capot 6a et le substrat semiconducteur 2a délimitent au niveau d'une face latérale 8 de la cellule une première rainure 7a longitudinale de logement d'un élément filaire électriquement conducteur. Le second capot 6b et le substrat semiconducteur 2b délimitent au niveau d'une face latérale 8 de la cellule une deuxième rainure 7b longitudinale de logement d'un second élément filaire électriquement conducteur. En outre, les premier 2a et second 2b substrats semiconducteurs sont, dans cet exemple, plus longs que la couche métallique 4 du côté de la face latérale 8. Ainsi, la couche métallique 4 et les premier et second substrats 2a, 2b délimitent au niveau de la face latérale 8 de la cellule une troisième rainure 7c longitudinale de logement d'un troisième élément filaire électriquement conducteur destiné à être relié à la couche métallique 4. Autrement dit, le second capot 6b étant transparent, le bloc 2 comporte deux substrats semiconducteurs 2a, 2b incluant des jonctions photovoltaïques séparées par une couche métallique 4, la cellule comportant de plus une troisième rainure 7c longitudinale de logement d'un troisième élément filaire électriquement conducteur destiné à être relié à ladite couche métallique 4. La troisième rainure 7c comporte un axe longitudinal, de préférence sensiblement parallèle à l'axe longitudinal de la première rainure 7a. De préférence, les trois rainures 7a, 7b, 7c sont formées dans une même face latérale 8 de la cellule pour faciliter son assemblage avec d'autres cellules. Une telle cellule peut recevoir des photons en provenance des deux faces principales de la cellule.

De préférence, des branches conductrices similaires à celles indiquées pour le mode de réalisation illustré en figure 6 sont respectivement interposées entre le premier capot 6a et le substrat 2a, et entre le second capot 6b et le substrat 2b. Bien entendu, si la cellule est de petites dimensions, les branches ne sont pas indispensables.

Dans ce mode de réalisation (figure 7), la cellule comprend deux jonctions photovoltaïques formées respectivement dans les substrats semiconducteurs 2a et 2b. Chaque jonction photovoltaïque est connectée à un premier et à un second élément de contact électrique. Le troisième élément filaire, placé dans la troisième rainure 7c, sera relié à un élément de contact de la jonction photovoltaïque supérieure (dans le substrat 2b) et à un élément de contact de la jonction photovoltaïque inférieure (dans le substrat 2a). Selon les connexions qui seront réalisées via les premier, deuxième et troisième éléments filaires encastrés dans les rainures de la cellule, les deux jonctions photovoltaïques peuvent être au final en série ou en parallèle.

Selon une variante, si la cellule est de petites dimensions, la couche métallique 4 peut être remplacée par un diélectrique. La troisième rainure 7c est alors délimitée par le diélectrique et deux portions opposées en regard des substrats semiconducteurs 2a et 2b. L'élément filaire inséré dans la troisième rainure 7c forme un élément de contact électrique commun aux deux jonctions photovoltaïques.

Un exemple d'assemblage de plusieurs cellules telles que celles de la figure 7 est décrit ci-après. On utilise un élément filaire électriquement conducteur en forme de Y présentant deux branches secondaires reliées à une branche principale. Les branches secondaires sont respectivement insérées dans les première et deuxième rainures 7a, 7b d'une cellule. La branche principale de l'élément filaire en forme de Y sera encastrée dans la troisième rainure 7c d'une cellule adjacente. Les deux jonctions photovoltaïques 2a, 2b de chaque cellule sont alors en parallèle et la cellule est équivalente à une unique jonction reliée à des premier et second pôles communs.

Dans ce type d'assemblage, l'élément filaire en forme de Y peut être composé de deux fils se rejoignant au niveau de la troisième rainure pour former la branche principale du Y.

Selon un quatrième mode de réalisation illustré à la figure 8, la cellule comporte toujours des premier et second capots 6a, 6b transparents délimitant chacun avec un bloc central 2 une rainure longitudinale de logement d'un élément filaire 7a, 7b. Le bloc 2 comporte deux substrats semiconducteurs 2a, 2b incluant des jonctions photovoltaïques, séparées par un diélectrique 2c. Une troisième rainure 7c longitudinale et une quatrième rainure 7d longitudinale, de préférence sensiblement parallèles à la première rainure 7a, sont formées respectivement au niveau des interfaces entre la couche de diélectrique 2c et les substrats semiconducteurs 2a, 2b associés. De préférence, les troisième 7c et quatrième 7d rainures sont réalisées dans la même face latérale de la cellule que les première et deuxième rainures 7a, 7b.

En outre, le bloc 2 peut comporter de part et d'autre du diélectrique 2c des couches métalliques 4a, 4b interposées entre les substrats semiconducteurs 2a, 2b et le diélectrique 2c. Les couches métalliques 4a, 4b permettent d'optimiser le rendement d'une cellule si ses dimensions ne permettent pas aux éléments filaires de récupérer toutes les charges générées dans les substrats semiconducteurs.

Selon une variante de réalisation applicable à tous les modes de réalisation, chaque capot 6a, 6b peut former un concentrateur des rayonnements solaires vers le substrat semiconducteur associé. Ceci permet d'améliorer le rendement de chaque cellule photovoltaïque. À titre d'exemple particulier, un capot transparent peut comporter une pluralité de lentilles faisant converger les photons dans le substrat semiconducteur associé.

De manière générale, le rendement de la cellule chute lorsque le semiconducteur chauffe. Ainsi, au moins un des capots peut former un dissipateur thermique, en utilisant, par exemple, un capot en forme de peigne constitué d'une matière thermo-conductrice. On pourra, par exemple, prévoir un capot transparent concentrateur et un capot dissipateur thermique.

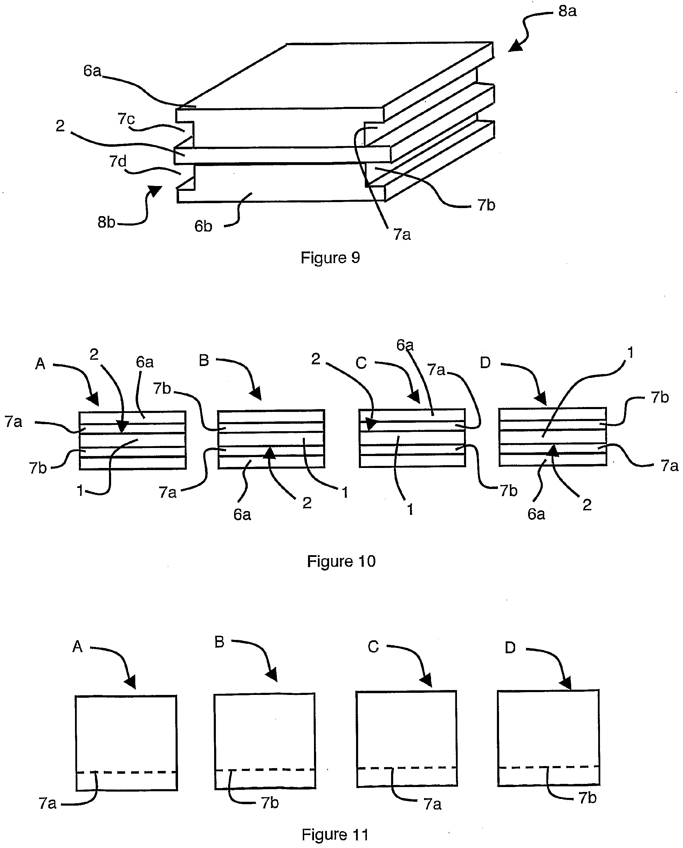

Selon un cinquième mode de réalisation illustré à la figure 9, la cellule est du type de celles illustrées aux figures 5 et 6, c'est à dire qu'elle comporte au niveau d'une première face latérale 8a des première et deuxième rainures 7a, 7b. La cellule de la figure 9 comporte en outre sur une deuxième face latérale 8b, opposée et, de préférence, parallèle à la première face latérale 8a, des troisième et quatrième rainures 7c, 7d longitudinales de logement d'un élément filaire. Ces rainures 7c, 7d sont, de préférence, aussi délimitées par un épaulement dans le capot associé et par le substrat semiconducteur. L'assemblage en série de deux cellules peut être réalisé par un premier élément filaire à la fois inséré dans la première rainure 7a d'une première cellule et dans la deuxième rainure 7b d'une deuxième cellule. De même un deuxième élément filaire est à la fois inséré dans la troisième rainure 7c de la première cellule et dans la quatrième rainure 7d rainure de la deuxième cellule. Ceci permet d'obtenir une série de cellules maintenues sur deux faces latérales opposées améliorant ainsi la solidité de l'assemblage. De plus, si l'un des éléments filaires rompt, le second pourra toujours assurer la continuité dans la série de cellules. En fonction des dimensions des cellules, ces éléments filaires peuvent suffire à former les premier et second éléments de contact électrique. Sinon, il est possible de former des branches entre chaque capot et le substrat comme précédemment décrit. Bien entendu, l'homme de l'art pourra adapter ce principe aux modes de réalisation des figures 7 et 8.

Grâce à de telles cellules, le substrat semiconducteur est protégé de l'environnement extérieur par les deux capots 6a, 6b ou par le premier capot 6a transparent et par la couche métallique 4 formée sous la cellule. Ainsi, contrairement aux procédés d'assemblage de cellules photovoltaïques classiques, il n'est pas nécessaire d'assembler les différentes cellules photovoltaïques selon l'invention dans un environnement spécifique présentant peu de poussières (pour éviter la contamination des substrats semiconducteurs).

De plus, les capots 6a, 6b apportent une certaine rigidité à l'ensemble, et permettent une manipulation plus aisée des cellules lors de l'assemblage. À titre d'exemple, l'épaisseur du substrat semiconducteur est de l'ordre de 200μm et chaque capot a une épaisseur 200μm.

Une pluralité de cellules telles que décrites peuvent être assemblées pour former un panneau photovoltaïque souple, pouvant être incorporé à un tissu. La souplesse du panneau est rendue possible par l'utilisation d'une pluralité de cellules de petite taille, de préférence inférieure à 5mm de côté.

De manière générale, un assemblage de cellules photovoltaïques comporte plusieurs cellules photovoltaïques reliées les unes aux autres par plusieurs éléments filaires, chaque élément filaire étant encastré dans les rainures d'au moins deux cellules photovoltaïques.

En outre, le procédé d'assemblage selon la présente invention permet de réaliser des panneaux photovoltaïques de très petites dimensions comportant quelques cellules de petite taille.

Dans le cas particulier où les cellules sont aptes à récupérer les rayonnements solaires des deux côtés (par deux capots transparents), un assemblage de telles cellules comporte une première face destinée à être orientée vers le soleil. Des moyens de réflexion peuvent être disposés au niveau de la seconde face de l'assemblage. En effet, lorsque la première face est orientée vers les rayonnements solaires, une partie des rayonnements solaires passe entre les cellules et n'est pas absorbée par l'intermédiaire de la première face. Les moyens de réflexion permettent alors de récupérer ces rayonnements et de les renvoyer vers les capots transparents de la seconde face. De tels moyens peuvent, par exemple, être formés par une feuille d'argent ou d'aluminium structurée ou non.

Selon un exemple particulier de réalisation d'un assemblage utilisant des cellules comportant dans une même face latérale deux rainures longitudinales de logement d'éléments filaires, illustré aux figures 10 et 11, les cellules sont tout d'abord positionnées sous la forme d'au moins une ligne de manière à former des première et deuxième rangées de rainures. Les cellules sont disposées de manière à ce que la première rainure 7a d'une cellule soit alignée avec la deuxième rainure 7b de la cellule adjacente. Comme l'illustre la figure 11 les cellules sont, de préférence, de taille et de forme identiques.

L'exemple particulier illustre quatre cellules A, B, C, D comportant chacune deux rainures longitudinales 7a, 7b au niveau d'une face latérale de la cellule photovoltaïque. Sur la figure 10, la cellule A et la cellule C ont leur premier capot 6a transparent orienté vers le haut, tandis que les cellules B et D ont leur premier capot 6a transparent orienté vers le bas. C'est pourquoi la première rangée de rainures (rangée du haut sur la figure 10) est composée (en allant de la gauche vers la droite) de la première rainure 7a de la cellule photovoltaïque A, de la deuxième rainure 7b de la cellule photovoltaïque B, de la première rainure 7a de la cellule photovoltaïque C et de la deuxième rainure 7b de la cellule photovoltaïque D. De la même manière, la deuxième rangée de rainures (rangée du bas sur la figure 10) est composée (en allant de la gauche vers la droite) de la deuxième rainure 7b de la cellule photovoltaïque A, de la première rainure 7a de la cellule photovoltaïque B, de la deuxième rainure 7b de la cellule photovoltaïque C et de la première rainure 7a de la cellule photovoltaïque D.

Après avoir positionné convenablement les cellules, ces dernières sont câblées au niveau de chaque ligne comme illustré aux figures 12 et 13. Un premier fil 11a électriquement conducteur est inséré dans chaque rainure de la première rangée de rainures (rainures du haut sur la figure 12), et un deuxième fil 11 b électriquement conducteur est inséré dans chaque rainure de la deuxième rangée de rainures (rainures du bas sur la figure 12). Ainsi, dans l'exemple particulier, le premier fil 11a passe dans la première rainure 7a de la cellule A, la deuxième rainure 7b de la cellule B, la première rainure 7a de la cellule C et la deuxième rainure 7b de la cellule D alors que le deuxième fil 11 b passe par la deuxième rainure 7b de la cellule A, la première rainure 7a de la cellule B, la deuxième rainure 7b de la cellule C et la première rainure 7a de la cellule D. Ensuite, les premier et deuxième fils 11 a et 11 b sont sectionnés alternativement entre deux cellules adjacentes (figure 14) pour former les premier et deuxième éléments filaires de chaque cellule. En fait, le premier élément filaire d'une cellule forme aussi le deuxième élément filaire de la cellule adjacente. Les premier et deuxième fils 11 a, 11 b doivent être de bon conducteurs avec de faibles pertes ohmiques. À titre d'exemple, il sera utilisé des fils de cuivre ou à base d'alliage de cuivre et d'argent.

Lors du sectionnement, comme l'illustre l'exemple particulier de la figure 14, le premier fil 11a situé dans les rainures en partie haute de la figure 12 est sectionné entre les cellules A et B, et entre les cellules C et D. Le deuxième fil 11 b situé dans les rainures basses est sectionné entre les cellules B et C. Au final, deux cellules adjacentes sont reliées par un unique segment de fil formant à la fois le premier élément filaire d'une cellule et le deuxième élément filaire de la cellule adjacente. La cellule A est reliée à la cellule B par un segment du deuxième fil 11 b, la cellule B étant reliée à la cellule C par un segment du premier fil 11a et la cellule C étant reliée à la cellule D par un segment du deuxième fil 11 b.

De préférence, afin d'éviter tout court-circuit, lorsqu'un fil 11 a, 11 b est sectionné entre deux cellules adjacentes, il est coupé au niveau de la rainure desdites deux cellules adjacentes comme sur la figure 14.

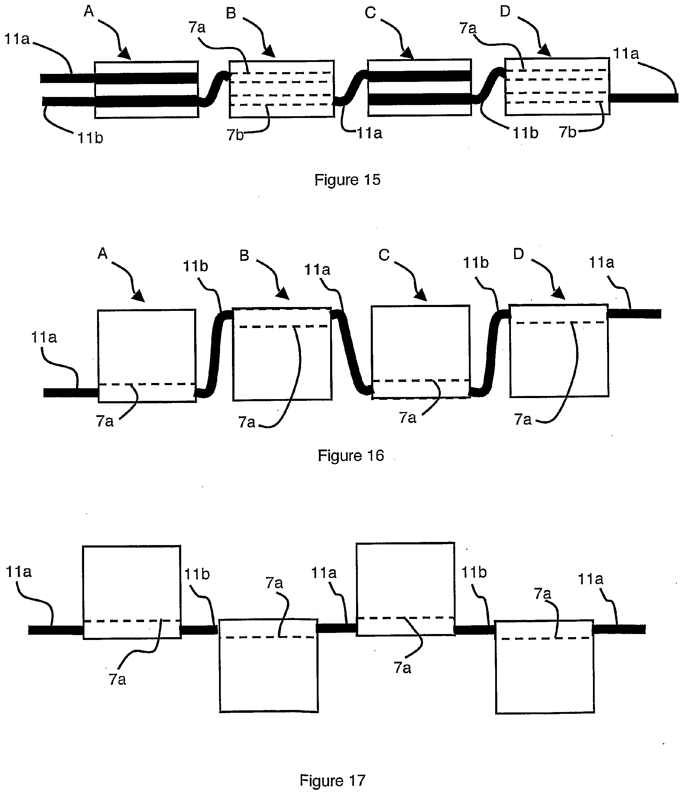

Après avoir sectionné convenablement les premier et deuxième fils 11 a, 11 b, une cellule photovoltaïque sur deux est retournée (figure 15) afin d'orienter tous les premiers capots des cellules d'un même côté. Par retourner, on entend que la cellule effectue une rotation de 180° par rapport à sa position initiale selon un axe parallèle aux premier et deuxième fils 11 a et 11 b.

Les figures 15 et 16 illustrent respectivement selon une vue de côté et une vue de dessus la configuration dans laquelle peuvent se retrouver les cellules après l'étape de retournement. La position des cellules A et C reste inchangée alors que la position des cellules B et D est inversée. Dans cette configuration, les premier capots 6a de chaque cellule sont tous orientés vers le haut et toutes les rainures 7a sont alors situées en partie haute de la ligne de cellules.

Selon une variante, après retournement des cellules photovoltaïques chaque ligne de cellules est ensuite étirée pour permettre aux cellules d'une même ligne d'être disposées alternativement de part et d'autre d'un axe central de la ligne de cellules, comme illustré à la figure 17.

Ce procédé permet de relier en série des cellules photovoltaïques telles que décrites de manière simplifiée et d'obtenir un assemblage souple.

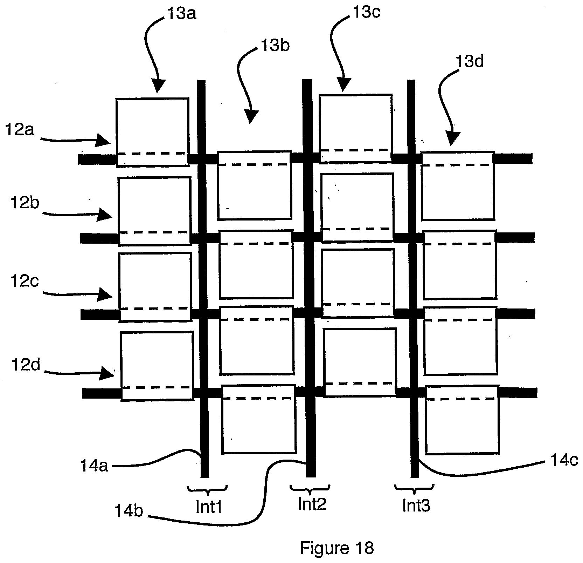

Le rendement d'une pluralité de lignes en série de cellules photovoltaïques peut être amélioré en réalisant un assemblage sous forme de matrice. Ainsi, dans une variante, le procédé d'assemblage comporte la réalisation d'une pluralité de lignes identiques de cellules. Après l'étape de retournement, et de préférence après l'étape d'étirement, les lignes sont disposées de manière à former une matrice de lignes et de colonnes de cellules comme à la figure 18. Deux colonnes de cellules adjacentes sont séparées par un intervalle. Ensuite, au niveau de chaque intervalle, un troisième fil relie électriquement les éléments filaires connectant deux cellules adjacentes de chaque ligne de la matrice au niveau de cet intervalle.

Selon l'exemple particulier de la figure 18, la matrice comporte quatre lignes 12a, 12b, 12c, 12d agencées de sorte à former quatre colonnes de cellules 13a, 13b, 13c, 13d. La première et la deuxième colonnes 13a, 13b, la deuxième et la troisième colonnes 13b, 13c, et la troisième et la quatrième colonnes 13c, 13d sont chacune séparées l'une de l'autre par un intervalle respectif Int1, Int2, Int3. Au niveau de chaque intervalle, un troisième fil 14a, 14b, 14c, est disposé et solidarisé électriquement à chaque ligne de cellules. Cette solidarisation électrique peut être réalisée par soudure du troisième fil au niveau de chaque segment d'élément filaire reliant deux cellules adjacentes d'une même ligne dans cet intervalle. Ainsi, à la figure 18, chaque ligne correspondant à une ligne de la figure 17, le fil 14a relie dans l'intervalle Int1 les éléments filaires de chaque ligne, le fil 14b relie dans l'intervalle Int2 les éléments filaires 11a de chaque ligne et le fil 14c relie dans l'intervalle Int3 les éléments filaires 11 b de chaque ligne.

Afin de limiter les pertes de performances lors de l'ombrage d'une ou de plusieurs cellules, il est possible d'utiliser des diodes mises en anti-parallèle (bypass diode en anglais) sur une ou plusieurs cellules solaires. En pratique, une cellule photovoltaïque peut être considérée comme un générateur de courant en parallèle avec une diode (formée par la jonction photovoltaïque de la cellule solaire), l'intensité du courant dépendant de l'éclairement incident de la cellule. Lorsque la cellule est ombrée, le courant est très faible voire nul. Sur une ligne de cellules photovoltaïques en série, si une cellule est ombrée, le courant généré par la ligne de cellule ne peut pas circuler dans cette dernière et la production de courant devient très faible ou nulle. Une diode en anti-parallèle permet de former une dérivation du courant pour limiter les impacts d'une cellule qui serait ombrée ou qui pourrait avoir un défaut de conception limitant son rendement. Plusieurs modes d'insertion de diodes en anti-parallèle sur un assemblage de cellules photovoltaïques selon la présente invention peuvent être envisagés par l'homme de l'art.

Dans le cas, par exemple, d'un assemblage tel que celui illustré en figure 18, il est possible d'ajouter une ligne supplémentaire de diodes en anti-parallèle, de sorte que chaque diode supplémentaire de cette ligne supplémentaire soit connectée en parallèle avec l'ensemble des cellules photovoltaïques d'une colonne. Plus précisément, les anode et cathode de chaque diode supplémentaire sont respectivement reliées aux cathodes et anodes des diodes formées par les jonctions photovoltaïques des cellules photovoltaïques d'une colonne. De telles diodes supplémentaires peuvent être réalisées chacune sous la forme d'une puce électronique présentant deux rainures munies de plots conducteurs reliés respectivement aux anode et cathode d'une diode de la puce électronique considérée. Les diodes supplémentaires peuvent alors être reliées les unes aux autres et aux cellules photovoltaïques de l'assemblage selon un procédé d'assemblage identique à celui décrit ci-dessus. De préférence, les dimensions de telles puces électroniques sont sensiblement les mêmes que celles des cellules photovoltaïques de l'assemblage pour garantir une bonne intégration de celles-ci dans l'assemblage.

À titre d'exemple particulier de réalisation, les diodes utilisées sont des diodes de Schottky. Ces diodes présentent l'avantage de posséder une chute de tension très faible (environ 0,3V) limitant le courant consommé par la dérivation.

Un tel procédé permet de fabriquer des panneaux, sous forme de matrice de cellules, souples et résilients. Ainsi, le panneau sera moins impacté par des zones d'ombres ou lors d'une défaillance de l'une des cellules. La meilleure tolérance de ce panneau lui permet d'obtenir des performances accrues lors de son utilisation sur des surfaces non planes. À titre d'exemple, le panneau peut être intégré à un vêtement ou à un sac à dos, il permet alors d'emmagasiner de l'énergie pour alimenter des équipements électroniques ou recharger des batteries. Cette intégration à des textiles n'est aujourd'hui pas facilement réalisable. En effet, une cellule de base existante sur support rigide fait environ 16 cm par 16 cm de côté. Cependant, grâce au procédé d'assemblage tel que décrit, il est possible à partir d'une cellule de base d'obtenir de l'ordre de 1024 cellules photovoltaïques sensiblement de forme carrée de 5mm de côté. Il est ensuite possible de relier ces éléments en matrice de trente-deux lignes et trente-deux colonnes. En utilisant des éléments filaires souples, on obtient au final un carré d'approximativement 16cm de côté présentant une certaine souplesse, convenable pour son intégration à un textile.

L'assemblage obtenu peut au final être noyé dans une colle souple ou encapsulé entre deux couches de matière plastique souple transparentes aux photons. Ceci permet à la fois de protéger les composants en assurant une protection contre la corrosion et l'eau, de garder la souplesse de l'assemblage, et d'éviter les courts-circuits entre les fils lorsque l'assemblage est sollicité.

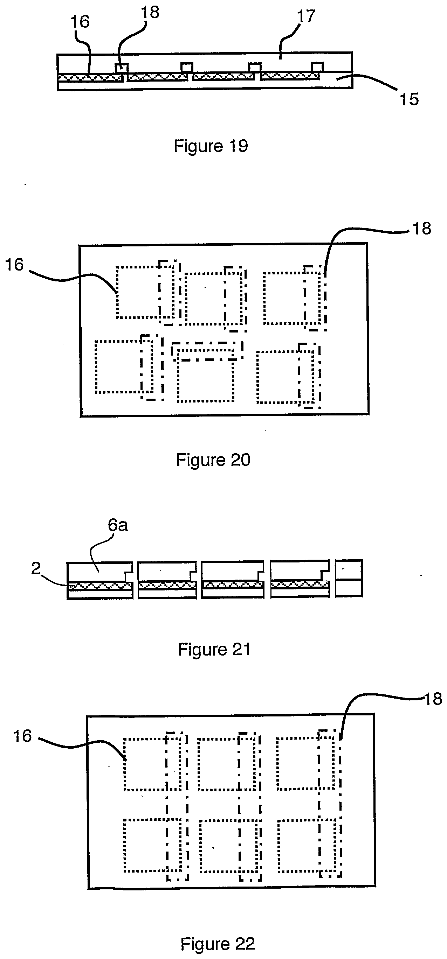

Un exemple de procédé de fabrication d'une pluralité de cellules photovoltaïques, telles que celles illustrées par les figures 2 à 9, est illustré aux figures 19 à 22. Dans une première étape, une pluralité de zones actives 16 sont réalisées sur une plaque active 15. Chaque zone active 16 comporte au moins une jonction photovoltaïque réalisée dans un matériau semiconducteur. Une telle plaque peut se présenter sous la forme d'une plaque de silicium sur laquelle une pluralité de zones actives 16 munies d'une jonction photovoltaïque sont réalisées.

Ensuite, une contre-plaque 17 d'un matériau transparent, par exemple du verre, peut être reportée sur la plaque active 15 pour former un assemblage. Cette contre-plaque 17 comporte des cavités 18 agencées de sorte que pour chaque zone active 16 de la plaque active 15, une cavité 18 vient en regard de l'un des bords de ladite zone active (figures 19 et 20). A la figure 20, les zones actives 16 étant disposées de manière non ordonnées, les cavités 18 sont réalisée en conséquence dans la contre-plaque 17.

Enfin, l'assemblage est découpé le long des bords des différentes zones actives 16 pour former les cellules. Le chemin de découpe traverse chaque cavité pour obtenir, après découpe, une pluralité de cellules comportant chacune au moins une rainure latérale (figure 21).

De préférence, les zones actives forment un quadrillage comme illustré à la figure 22 pour optimiser le nombre de zones actives réalisées sur la plaque active. Ainsi, les cavités 18 de la contre-plaque 17 peuvent être réalisées par une pluralité de tranchées sensiblement parallèles facilitant la découpe de l'assemblage.

Selon une variante de réalisation du procédé, la plaque active 15 est recouverte d'une couche active et les cavités 18 de la contre-plaque peuvent être réalisées par une pluralité de tranchées sensiblement parallèles facilitant la découpe de l'assemblage. En effet, la zone active peut être une simple jonction PN, il n'est alors pas nécessaire de délimiter au préalable des zones actives pour chaque cellule.

Afin de réaliser des cellules photovoltaïques à deux capots, on pourra, avant découpe dudit assemblage, rajouter une seconde contre-plaque sur la face arrière de la plaque active 15. La contre-plaque en face arrière comprend, de préférence, des cavités, ou des ouvertures, destinées à former après découpe de l'assemblage, des rainures de logement d'un élément filaire placées respectivement sur une face latérale ou sur la face arrière d'une cellule.

Selon une variante de fabrication, la plaque active 15 peut être amincie par sa face arrière afin de réaliser des cellules de faible épaisseur. De même, dans le cas où la plaque active 15 comprend une couche métallique, celle-ci peut éventuellement être amincie.

Une fois la contre-plaque 17 solidarisée avec la plaque active 15, la plaque active 15 peut être amincie de sorte à laisser affleurer les zones actives 16 avant le report d'une autre contre-plaque sur la face arrière de la plaque active 15. Ceci permet notamment de réaliser une cellule telle qu'illustrée à la figure 6, c'est-à-dire avec deux capots transparents.

D'autres modes de réalisation d'une cellule photovoltaïque selon l'invention ainsi que d'autres procédés d'assemblage de cellules photovoltaïques peuvent être imaginés par l'homme de l'art. Ainsi, bien que dans les exemples de cellules décrites précédemment les capots soient placés directement sur des substrats semiconducteurs, on pourra placer les capots sur une autre couche constitutive du bloc central.

## Revendications

1. Cellule photovoltaïque comportant :
• des faces principales opposées connectées par des faces latérales,
• un bloc (2) incluant au moins un substrat (2a) semi-conducteur dans lequel est formée au moins une jonction photovoltaïque connectée à un premier élément de contact électrique d'un premier pôle et à un second élément de contact électrique d'un second pôle,
**caractérisé en ce qu'**elle comporte
• un premier élément filaire électriquement conducteur connecté au premier élément de contact électrique ou au deuxième élément de contact électrique,
• un premier capot (6a) transparent disposé sur une première face du bloc (2) et délimitant avec ledit bloc (2) une première rainure longitudinale (7a) de logement du premier élément filaire électriquement conducteur située sur une face latérale externe de la cellule photovoltaïque.

2. Cellule photovoltaïque selon la revendication 1, **caractérisée en ce qu'**elle comporte un second capot (6b) disposé sur une seconde face du bloc (2), opposée à la première face du bloc (2), et délimitant avec le bloc (2) de la cellule une deuxième rainure (7b) de logement d'un deuxième élément filaire électriquement conducteur.

3. Cellule photovoltaïque selon la revendication 2, **caractérisée en ce que** ladite deuxième rainure (7b) est une rainure longitudinale de logement du deuxième élément filaire électriquement conducteur dans une face latérale (8) de la cellule photovoltaïque.

4. Cellule photovoltaïque selon la revendication 2, **caractérisée en ce que** ladite deuxième rainure (7b) est une rainure longitudinale de logement du deuxième élément filaire électriquement conducteur dans une face principale externe de la cellule photovoltaïque.

5. Cellule photovoltaïque selon l'une des revendications 2 et 3, **caractérisée en ce que** le second capot (6b) et/ou le premier capot (6a) sont placés directement sur le substrat semi-conducteur.

6. Cellule photovoltaïque selon l'une des revendications précédentes, **caractérisée en ce qu'**au moins un des éléments de contact électrique connecté à la jonction photovoltaïque comprend le premier élément filaire électriquement conducteur encastré dans la première rainure.

7. Cellule photovoltaïque selon l'une des revendications précédentes, **caractérisée en ce qu'**un des éléments de contact électrique comporte une couche métallique (4) recouvrant le substrat semi-conducteur.

8. Cellule photovoltaïque selon l'une des revendications précédentes, **caractérisée en ce qu'**au moins un des éléments de contact électrique comporte une pluralité de branches conductrices (10) disposées sur une face du substrat semi-conducteur, lesdites branches (10) étant destinées à être en contact ou reliées au premier élément filaire électriquement conducteur.

9. Cellule photovoltaïque selon l'une des revendications précédentes **caractérisée en ce qu'**elle comporte un unique substrat semi-conducteur incluant une jonction photovoltaïque.

10. Cellule photovoltaïque selon l'une des revendications 2 et 3, **caractérisée en ce que** le second capot (6b) étant transparent, le bloc (2) comporte deux substrats semi-conducteurs (2a, 2b) incluant des jonctions photovoltaïques séparées par une couche métallique (4), la cellule photovoltaïque comportant une troisième rainure (7c) longitudinale de logement d'un troisième élément filaire électriquement conducteur destiné à être relié à ladite couche métallique (4).

11. Cellule photovoltaïque selon l'une des revendications 2 et 3, **caractérisée en ce que** le bloc (2) comporte deux substrats semi-conducteurs (2a, 2b) incluant des jonctions photovoltaïques séparées par un diélectrique (2c), la cellule photovoltaïque comportant des troisième et quatrième rainures formées respectivement au niveau d'une face latérale (8) à l'interface entre la couche de diélectrique (2c) et les substrats semi-conducteurs associés.

12. Cellule photovoltaïque selon la revendication 11, **caractérisée en ce que** de part et d'autre du diélectrique (2c) une couche métallique (4a, 4b) est interposée entre le diélectrique et substrat semi-conducteur (2a, 2b) associé.

13. Assemblage de cellules photovoltaïques comprenant plusieurs cellules photovoltaïques selon l'une des revendications précédentes **caractérisé en ce que** les cellules photovoltaïques sont reliées les unes aux autres par plusieurs éléments filaires électriquement conducteurs, chaque élément filaire étant encastré dans les premières rainures d'au moins deux cellules photovoltaïques.

14. Procédé d'assemblage d'une pluralité de cellules photovoltaïques selon la revendication 13, **caractérisé en ce que** chaque cellule photovoltaïque comportant des première et deuxième rainures (7a, 7b) formées au niveau d'une même face latérale (8), le procédé comporte les étapes successives suivantes :
- le positionnement des cellules photovoltaïque sous la forme d'au moins une ligne de manière à former des première et deuxième rangées de rainures, la première rainure (7a) d'une cellule photovoltaïque étant alignée avec la deuxième rainure (7b) de la cellule photovoltaïque adjacente,
- le câblage de chaque ligne de cellules photovoltaïques, un premier élément filaire (11 a) électriquement conducteur étant inséré dans chaque rainure de la première rangée de rainures, et un deuxième élément filaire (11b) électriquement conducteur étant inséré dans chaque rainure de la deuxième rangée de rainures,
- le sectionnement alternatif des premier et deuxième éléments filaires (11 a, 11 b) électriquement conducteurs entre deux cellules photovoltaïques adjacentes,
- le retournement d'une cellule photovoltaïque sur deux afin d'orienter tous les premiers capots des cellules photovoltaïques d'un même côté.

15. Procédé selon la revendication 14, **caractérisé en ce qu'**après l'étape de retournement des cellules photovoltaïques, chaque ligne est étirée, les cellules photovoltaïques d'une même ligne étant alors disposées alternativement de part et d'autre d'un axe central de la ligne.

16. Procédé d'assemblage d'une pluralité de cellules photovoltaïques, **caractérisé en ce qu'**il comporte la réalisation d'une pluralité de lignes identiques de cellules photovoltaïques (12a, 12b, 12c, 12d) selon le procédé de la revendication 14 ou 15, et **en ce qu'**après l'étape de retournement, les lignes sont disposées de manière à former une matrice de lignes (12a, 12b, 12c, 12d) et de colonnes (13a, 13b, 13c, 13d), un troisième élément filaire (14a, 14b, 14c) électriquement conducteur étant disposé dans chaque intervalle (Int1, Int2, Int3) formé entre deux colonnes adjacentes de la matrice, chaque troisième élément filaire (14a, 14b, 14c) électriquement conducteur reliant électriquement les premier et deuxième éléments filaires (11 a, 11 b) électriquement conducteurs connectant deux cellules photovoltaïques adjacentes de chaque ligne (12a, 12b, 12c, 12d) de la matrice.

## Patentansprüche

1. Photovoltaikzelle, umfassend:
- gegenüberliegende Hauptseiten, die über Seitenflächen verbunden sind,
- einen Block (2), der wenigstens ein Halbleitersubstrat (2a) einschließt, in dem wenigstens ein photovoltaischer Übergang, welcher mit einem ersten elektrischen Kontaktelement eines ersten Pols und mit einem zweiten elektrischen Kontaktelement eines zweiten Pols verbunden ist, ausgebildet ist,
**dadurch gekennzeichnet, dass** sie umfasst
- ein erstes elektrisch leitendes Drahtelement, das mit dem ersten elektrischen Kontaktelement oder mit dem zweiten elektrischen Kontaktelement verbunden ist,
- eine erste transparente Kappe (6a), die auf einer ersten Seite des Blocks (2) angeordnet ist und mit dem Block (2) eine erste Längsnut (7a) zur Aufnahme des ersten elektrisch leitenden Drahtelements, welche an einer äußeren Seitenfläche der Photovoltaikzelle gelegen ist, begrenzt.

2. Photovoltaikzelle nach Anspruch 1, **dadurch gekennzeichnet, dass** sie eine zweite Kappe (6b) umfasst, die auf einer zu der ersten Seite des Blocks (2) entgegengesetzten zweiten Seite des Blocks (2) angeordnet ist und mit dem Block (2) der Zelle eine zweite Nut (7b) zur Aufnahme eines zweiten elektrisch leitenden Drahtelements begrenzt.

3. Photovoltaikzelle nach Anspruch 2, **dadurch gekennzeichnet, dass** die zweite Nut (7b) eine Längsnut zur Aufnahme des zweiten elektrisch leitenden Drahtelements in einer Seitenfläche (8) der Photovoltaikzelle ist.

4. Photovoltaikzelle nach Anspruch 2, **dadurch gekennzeichnet, dass** die zweite Nut (7b) eine Längsnut zur Aufnahme des zweiten elektrisch leitenden Drahtelements in einer äußeren Hauptseite der Photovoltaikzelle ist.

5. Photovoltaikzelle nach einem der Ansprüche 2 und 3, **dadurch gekennzeichnet, dass** die zweite Kappe (6b) und/oder die erste Kappe (6a) direkt auf dem Halbleitersubstrat angeordnet sind.

6. Photovoltaikzelle nach einem der vorhergehenden Ansprüche, **dadurch gekennzeichnet, dass** wenigstens eines der elektrischen Kontaktelemente, das mit dem photovoltaischen Übergang verbunden ist, das in die erste Nut eingebettete erste elektrisch leitende Drahtelement umfasst.

7. Photovoltaikzelle nach einem der vorhergehenden Ansprüche, **dadurch gekennzeichnet, dass** eines der elektrischen Kontaktelemente eine Metallschicht (4), welche das Halbleitersubstrat bedeckt, umfasst.

8. Photovoltaikzelle nach einem der vorhergehenden Ansprüche, **dadurch gekennzeichnet, dass** wenigstens eines der elektrischen Kontaktelemente eine Vielzahl von leitenden Zweigen (10), die auf einer Seite des Halbleitersubstrats angeordnet sind, umfasst, wobei die Zweige (10) dazu bestimmt sind, mit den ersten elektrisch leitenden Drahtelement in Kontakt oder verbunden zu sein.

9. Photovoltaikzelle nach einem der vorhergehenden Ansprüche, **dadurch gekennzeichnet, dass** sie ein einziges, einen photovoltaischen Übergang einschließendes Halbleitersubstrat umfasst.

10. Photovoltaikzelle nach einem der Ansprüche 2 und 3, **dadurch gekennzeichnet, dass**, da die zweite Kappe (6b) transparent ist, der Block (2) zwei Halbleitersubstrate (2a, 2b), die durch eine Metallschicht (4) getrennte photovoltaische Übergänge einschließen, umfasst, wobei die Photovoltaikzelle eine dritte Längsnut (7c) zur Aufnahme eines dritten elektrisch leitenden Drahtelements, welches dazu bestimmt ist, mit der Metallschicht (4) verbunden zu werden, umfasst.

11. Photovoltaikzelle nach einem der Ansprüche 2 und 3, **dadurch gekennzeichnet, dass** der Block (2) zwei Halbleitersubstrate (2a, 2b), welche durch ein Dielektrikum (2c) getrennte photovoltaische Übergänge einschließen, umfasst, wobei die Photovoltaikzelle eine dritte und eine vierte Nut umfasst, die jeweils im Bereich einer Seitenfläche (8) an der Schnittstelle zwischen der Dielektrikumsschicht (2a) und den zugeordneten Halbleitersubstraten ausgebildet sind.

12. Photovoltaikzelle nach Anspruch 11, **dadurch gekennzeichnet, dass** auf beiden Seiten des Dielektrikums (2c) eine Metallschicht (4a, 4b) zwischen dem Dielektrikum und dem zugeordneten Halbleitersubstrat (2a, 2b) eingefügt ist.

13. Anordnung von Photovoltaikzellen, umfassend mehrere Photovoltaikzellen nach einem der vorhergehenden Ansprüche, **dadurch gekennzeichnet, dass** die Photovoltaikzellen durch mehrere elektrisch leitende Drahtelemente miteinander verbunden sind, wobei jedes Drahtelement in die ersten Nuten von wenigstens zwei Photovoltaikzellen eingebettet ist.

14. Verfahren zum Zusammenfügen einer Vielzahl von Photovoltaikzellen nach Anspruch 13, **dadurch gekennzeichnet, dass**, da jede Photovoltaikzelle eine erste und eine zweite Nut (7a, 7b), welche im Bereich einer gleichen Seitenfläche (8) ausgebildet sind, umfasst, das Verfahren die folgenden aufeinanderfolgenden Schritte umfasst:
- das Positionieren der Photovoltaikzellen in Form wenigstens einer Zeile, so dass eine erste und eine zweite Reihe von Nuten gebildet werden, wobei die erste Nut (7a) einer Photovoltaikzelle mit dem zweiten Nut (7b) der benachbarten Photovoltaikzelle fluchtet,
- das Verkabeln einer jeden Zeile von Photovoltaikzellen, wobei ein erstes elektrisch leitendes Drahtelement (11a) in jede Nut der ersten Reihe von Nuten eingesetzt wird und ein zweites elektrisch leitendes Drahtelement (11b) in jede Nut der zweiten Reihe von Nuten eingesetzt wird,
- das abwechselnde Trennen der ersten und zweiten elektrisch leitenden Drahtelemente (11a, 11b) zwischen zwei benachbarten Photovoltaikzellen,
- das Wenden jeder zweiten Photovoltaikzelle, um alle ersten Kappen der Photovoltaikzellen auf einer gleichen Seite auszurichten.

15. Verfahren nach Anspruch 14, **dadurch gekennzeichnet, dass** nach dem Schritt des Wendens der Photovoltaikzellen jede Zeile gestreckt wird, wobei die Photovoltaikzellen einer gleichen Zeile dann abwechselnd auf beiden Seiten einer Mittelachse der Zeile angeordnet sind.

16. Verfahren zum Zusammenfügen einer Vielzahl von Photovoltaikzellen, **dadurch gekennzeichnet, dass** es die Ausbildung einer Vielzahl von identischen Zeilen von Photovoltaikzellen (12a, 12b, 12c, 12d) nach dem Verfahren des Anspruches 14 oder 15 umfasst und dass nach dem Wendeschritt die Zeilen derart angeordnet sind, dass eine Matrix aus Zeilen (12a, 12b, 12c, 12d) und Spalten (13a, 13b, 13c, 13d) gebildet wird, wobei eine drittes elektrisch leitendes Drahtelement (14a, 14b, 14c) in jedem Zwischenraum (Int1, Int2, Int3), der zwischen zwei benachbarten Spalten der Matrix gebildet ist, angeordnet ist, wobei jedes dritte elektrisch leitende Drahtelement (14a, 14b, 14c) das erste und das zweite elektrisch leitende Drahtelement (11a, 11b), welche zwei benachbarte Photovoltaikzellen einer jeden Zeile (12a, 12b, 12c, 12d) der Matrix verbinden, elektrisch verbindet.

## Claims

1. Photovoltaic cell comprising:
• opposite main faces connected by side faces,
• a block (2) including at least one semiconductor substrate (2a) in which is formed at least one photovoltaic junction connected to a first electrical contact element with a first pole and to a second electrical contact element with a second pole,
**characterized in that** it comprises:
• a first electrically conducting wire element connected to the first electrical contact element or the second electrical contact element,
• a first transparent cover (6a) arranged on a first main face of the block (2) and delimiting with said block (2) a first groove (7a) for housing the first electrically conducting wire element placed on an external side face of the photovoltaic cell.

2. Photovoltaic cell according to claim 1, **characterized in that** it comprises a second cover (6b) arranged on a second face of the block (2), opposite the first face of the block (2), and delimiting with the block (2) of the cell a second groove (7b) for housing a second wire electrically conducting element.

3. Photovoltaic cell according to claim 2, **characterized in that** said second groove (7b) is a longitudinal groove for housing the second wire electrically conducting element in a side face (8) of the photovoltaic cell.

4. Photovoltaic cell according to claim 2, **characterized in that** said second groove (7b) is a longitudinal groove for housing the second wire electrically conducting element in a main face (8) of the photovoltaic cell.

5. Photovoltaic cell according to any one of claims 3 or 4, **characterized in that** the second cover (6b) and/or the first cover (6a) are placed directly onto the semiconductor substrate.

6. Photovoltaic cell according to any one of the preceding claims, **characterized in that** at least one of the electrical contact elements connected to the photovoltaic junction includes the first electrically conducting wire element embedded in the first groove.

7. Photovoltaic cell according to any one of the preceding claims, **characterized in that** one of the electrical contact elements comprises a metal layer (4) covering the semiconductor substrate.

8. Photovoltaic cell according to any one of the preceding claims, **characterized in that** at least one of the electrical contact elements comprises a plurality of conducting arms (10) arranged on a face of the semiconductor substrate, said arms (10) being designed to be in contact with or to be connected to a wire element.

9. Photovoltaic cell according to any one of the preceding claims **characterized in that** it comprises a single semiconductor substrate including a photovoltaic junction.

10. Photovoltaic cell according to any one of the claims 2 and 3, **characterized in that** the second cover (6b) being transparent, the block (2) comprises two semiconductor substrates (2a, 2b) including photovoltaic junctions separated by a metal layer (4), the cell comprising a third longitudinal groove (7c) for housing a third electrically conducting wire element designed to be connected to said metal layer (4).

11. Photovoltaic cell according to any one of the claims 2 and 3, **characterized in that** the block (2) comprises two semiconductor substrates (2a, 2b) including photovoltaic junctions separated by a dielectric (2c), the cell comprising third and fourth grooves respectively formed on a side face (8) at the interface between the dielectric layer (2c) and the associated semiconductor substrates.

12. Photovoltaic cell according to claim 11, **characterized in that** on both sides of the dielectric (2c) a metal layer (4a, 4b) is interposed between the dielectric and the associated semiconductor substrate (2a, 2b).

13. Assembly of photovoltaic cells including several photovoltaic cells according to any one of the preceding claims, **characterized in that** the cells are connected to one another by several wire elements, each wire element being embedded in the grooves of at least two photovoltaic cells.

14. Method for assembling a plurality of photovoltaic cells according to claim 13, **characterized in that** each cell comprising first and second grooves (7a, 7b) formed on the same side face (8), the method comprises the following successive steps:
• positioning cells in the form of at least one line so as to form first and second rows of grooves, the first groove (7a) of a cell being aligned with the second groove (7b) of the adjacent cell,
• wiring each line of cells, a first electrically conducting wire element (11a) being inserted in each groove of the first line of grooves, and a second electrically conducting wire element (11b) being inserted in each groove of the second line of grooves,
• alternatively sectioning the first and second electrically conducting wire elements (11 a, 11 b) between two adjacent cells,
• turning over every second photovoltaic cell in order to orient all the first covers of the photovoltaic cells towards the same side.

15. Method according to claim 14, **characterized in that** after the step of turning over the cells, each line is stretched, photovoltaic cells of the same line being then arranged alternatively on either sides of a central axis of the line.

16. Method for assembling a plurality of photovoltaic cells, **characterized in that** it comprises the making of a plurality of identical lines of photovoltaic cells (12a, 12b, 12c, 12d) according to the method according to claim 14 or 15, and **in that** after the turning-over step, the lines are arranged so as to form a matrix of lines (12a, 12b, 12c, 12d) and columns (13a, 13b, 13c, 13d), a third electrically conducting wire element (14a, 14b, 14c) being arranged in each interval (Int1, Int2, Int3) formed between two adjacent columns of the matrix, each third electrically conducting wire element (14a, 14b, 14c) electrically connecting together the first and second electrically conducting wire elements (11a, 11 b) connecting two adjacent photovoltaic cells of each line (12a, 12b, 12c, 12d) of the matrix.
